Europäisches Patentamt

European Patent Office

Office européen des brevets

(11) Publication number: **0 032 030**
**B1**

# EUROPEAN PATENT SPECIFICATION

(45) Date of publication of patent specification: **14.08.85**

(21) Application number: **80304617.6**

(22) Date of filing: **19.12.80**

(51) Int. Cl.⁴: **H 01 L 27/10,** G 11 C 11/24,
H 01 L 29/94

(54) **A semiconductor device and a method of manufacturing a semiconductor device.**

(30) Priority: **29.12.79 JP 171195/79**

(43) Date of publication of application:
**15.07.81 Bulletin 81/28**

(45) Publication of the grant of the patent:
**14.08.85 Bulletin 85/33**

(84) Designated Contracting States:
**DE FR GB NL**

(56) References cited:
**FR-A-2 397 069**
**US-A-4 115 871**

**IBM TECHNICAL DISCLOSURE BULLETIN, vol.
16, no. 2, July 1973, New York, USA R.H.
DENNARD et al. "Selfaligned field shield
process", pages 507, 508**
**ELECTRONIC DESIGN, vol. 26, no. 11, May
1978, Rochelle-Park, USA "Alpha particles may
be cause of soft errors in memory", page 37**

(73) Proprietor: **FUJITSU LIMITED**
**1015, Kamikodanaka Nakahara-ku
Kawasaki-shi Kanagawa 211 (JP)**

(72) Inventor: **Nakano, Motoo
312-3-9-913, Imai-cho Hodogaya-ku
Yokohama-shi Kanagawa 240 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

## Description

This invention relates to a semiconductor device and a method of manufacturing a semiconductor device.

Previously, the so-called channel cut system has been proposed for isolating, for example, one memory cell from another in a semiconductor memory device. That is, each memory cell, for example of the 1-transistor, 1-capacitor type, is surrounded by a high impurity concentration area which is called a channel cut area, selectively formed in a surface portion of a semiconductor substrate. To maintain self alignment for each layer of a semiconductor memory cell, a previously proposed channel cut process comprises a step for covering an active area of a memory cell, including a transistor area of the memory cell, with a mask of silicon nitride, a step for selectively introducing an impurity into an area not covered by the mask, and a step for growing a thick field silicon oxide layer except on the mask.

From the practical view point, however, this previously proposed channel cut process using a thick field oxide layer has an inevitable drawback in that the area of the active area is subjected to an unintentional decrease, because the field silicon oxide layer tends to grow towards the active area and a long duration heat treatment causes impurity doped for the purpose of the channel cut system to diffuse towards the active area.

Not only a capacitor constituted by a silicon oxide layer grown on a substrate and a conductive layer grown on the silicon oxide layer and a high impurity concentration layer doped beneath the silicon oxide layer might be considered, but a further capacitor constituted by a depletion layer spreading beneath the high impurity concentration layer at an interface or p—n junction formed between the substrate and the high impurity concentration layer might be considered for useful employment to decrease the size of the capacitor for the memory cell. To increase the capacitance of the latter capacitor for reducing capacitor size, another high impurity concentration layer of the same conductivity type as that of the substrate can be interleaved or interposed between the first high impurity concentration layer and the substrate. This, however, involves a drawback in that the other high impurity concentration layer of the same conductivity type as that of the substrate reaches the gate of a transfer gate transistor; the threshold voltage Vth of that transistor is increased.

Further, for the purpose of preventing inversion of conductivity from occurring at the surface of the substrate in the field area, a so-called field shield system can be employed rather than some of the conventional means for the same purpose such as the channel cut system. This field shield system has a drawback in that it tends to result in a lesser magnitude of circuit integration due to the additional masking process required to form the pattern of the field shield layer. Moreover, unlike the channel cut diffusion system, the field shield system is ineffective in preventing surface inversion originating from the characteristics of the insulator layer thereunder.

United States Patent Specification No. 4,115,871 discloses a semiconductor memory device having the precharacterising features of claim 1. In this disclosure, the device has a memory cell of the one transistor, one capacitor type, comprising a semiconductor substrate of one conductivity type, the memory cell comprising an insulator layer on the surface of the substrate, a first semiconductor region, of the opposite conductivity type to that of the substrate, beneath the insulator layer, providing one electrode of the capacitor, a second semiconductor region, of the same conductivity type as the substrate and with higher conductivity than the substrate, beneath the first semiconductor region a conductive layer, above the insulator layer, over the first and second semiconductor regions, providing another electrode of the said capacitor.

IBM Technical Disclosure Bulletin, Volume 16, No. 2, July 1983, pages 507 and 508, discloses a self-aligned field shield process for a one-device field-effect transistor memory cell. The process employs a field shield.

According to the present invention there is provided a semiconductor memory device having a memory cell of the one transistor, one capacitor type, comprising a semiconductor substrate of one conductivity type, the memory cell comprising an insulator layer on the surface of the substrate, a first semiconductor region, of the opposite conductivity type to that of the substrate, beneath the insulator layer, providing one electrode of the capacitor, a second semiconductor region, of the same conductivity type as the substrate and with higher conductivity than the substrate, beneath the first semiconductor region, a conductive layer, above the insulator layer, over the first and second semiconductor regions, providing another electrode of the said capacitor, characterised in that

the second semiconductor region is connected with a channel cut region of the same conductivity type as the substrate, and with higher conductivity than the substrate, in that

the channel cut region is provided beneath the insulator layer in the field area, the field area comprising that part of the substrate which does not contain a capacitor or transistor region, and in that

the conductive layer additionally overlies said field area so as to constitute both an electrode of the capacitor and a field shield electrode.

According to the present invention there is also provided a method of manufacturing a semiconductor device as claimed in any one of claims 1—6 wherein a thick field oxide layer is not employed or produced, and no long duration high temperature heat treatments are used for producing the channel cut region.

An embodiment of this invention can provide a semiconductor device, for example a memory device, which is highly integrated.

An embodiment of this invention can provide a semiconductor memory device having a long persistence time (memory holding time).

An embodiment of this invention can provide a semiconductor device, for example a memory device, with a plane surface and which is resistant to α rays.

A semiconductor memory device embodying this invention is provided with a capacitor constituted by (a) an insulator layer grown on a substrate of one conductivity type, (b) a conductive layer grown on the insulator layer to provide one electrode of a capacitor of the memory device, extending to the field area to form a field shield layer, (c) a first, semiconductor region of the opposite conductivity type to that of the substrate, located beneath the insulator layer to provide the other electrode of the capacitor and a source of a transfer gate transistor and (d) a second, highly doped, semiconductor region of the same conductivity type as that of the substrate, located beneath the first semiconductor region extending towards the field area but not towards a gate region of the transfer gate transistor, and being connected to the channel cut region in the field area. This configuration can provide for (i) increase in capacitance, (ii) isolation of the capacitor from the gate of a transfer gate transistor and (iii) channel cut.

Reference is made, by way of example, to the accompanying drawings, in which:—

Figure 1 is a schematic cross-sectional view of a semiconductor wafer or substrate after a first step for production of a semiconductor memory cell embodying this invention;

Figure 2(a) is a schematic cross-sectional view of a semiconductor wafer or substrate after a second step for production of a semiconductor memory cell embodying this invention;

Figure 2(b) is a schematic plan view corresponding to Figure 2(a);

Figures 3 to 6(a) are schematic cross-sectional views of a semiconductor wafer or substrate after third, fourth, fifth and sixth production steps, respectively:

Figure 6(b) is a schematic plan view corresponding to Figure 6(a);

Figures 7 to 10 are schematic cross-sectional views of a semiconductor wafer or substrate after tenth, eleventh, twelfth and seventeenth steps, respectively;

Figure 11(a) is a schematic plan view of a part of a completed semiconductor memory device embodying this invention;

Figure 11(b) is a schematic cross-sectional view taken along line X—Y of Figure 11(a);

Figure 11(c) is a schematic cross-sectional view taken along line X'—Y' in Figure 11(a); and

Figures 12 to 16 are, respectively, schematic cross-sectional views of a semiconductor wafer or substrate after fifth, ninth, fourteenth, twenty first and final steps for production of a semiconductor memory cell in accordance with another embodiment of this invention.

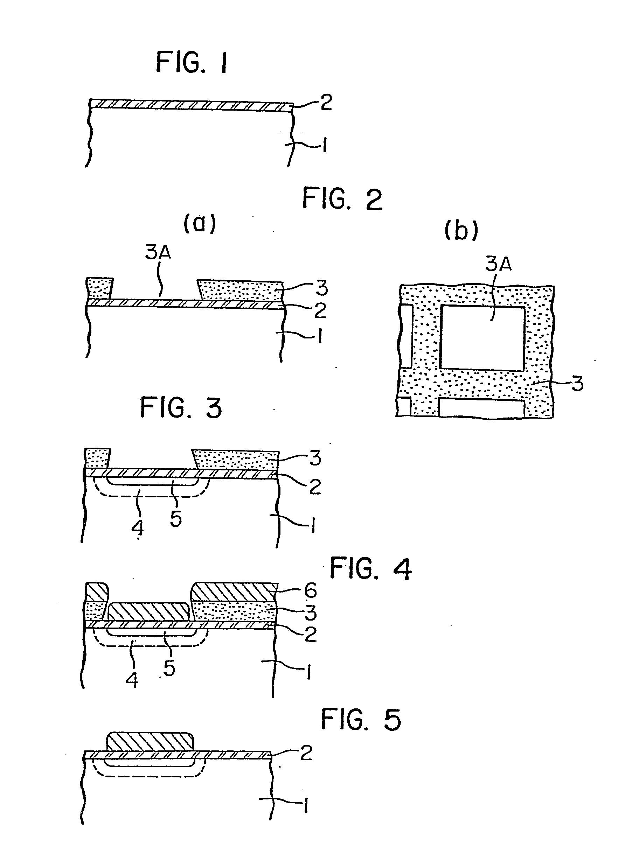

With reference to Figures 1 to 11 and 12 to 16 the steps for production of, and the arrangement and configuration of, two independent embodiments of this invention will be described below.

With reference to Figures 1 to 10, steps for production of one semiconductor memory device embodying this invention will be described on the assumption that the device is produced on a p-doped silicon substrate.

Referring to Figure 1, a first step is to grow an silicon dioxide layer 2 to a thickness of, for example, 20—40 nm on a p-doped silicon substrate 1. Any process can be accepted for this purpose. The silicon dioxide layer 2 functions as a dielectric layer for a capacitor and as a field insulator layer. Depending on the specific conditions prevailing, a double layer consisting of a silicon dioxide layer and a silicon nitride layer may be preferable in some circumstances.

Referring to Figures 2(a) and (b), an ordinary lithography process is employed for production of an opening 3A in a resist film 3 which is coated on the silicon oxide layer 2 to an approximate thickness of 1 μm. Referring to Figure 3, ion implantation processes are employed for production of a $p^+$ region 4 and thereafter an $n^+$ region 5 in the p-doped substrate 1. As shown in Figure 3, the dimensions of the former region are larger than those of the latter. The dopants for these processes are respectively, for example, boron and arsenic.

Referring to Figure 4, a second mask 6 is produced over the entire surface of the wafer or substrate (and, of course, over layers 2 and 3). The material of the mask 6 must be different from that of the resist mask 3. The material may be aluminium. In this case, evaporation is a convenient method for production of this mask. Referring to Figure 5, a so-called lift off process is employed for removing the resist film 3, leaving the different mask 6 in place (where mask 6 was not formed on resist film 3).

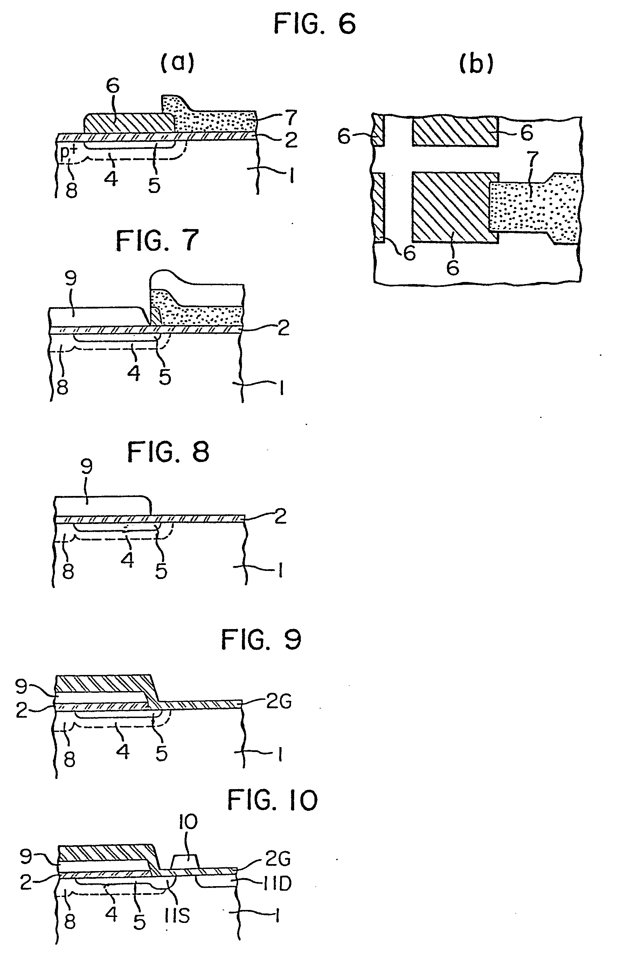

Referring to Figures 6(a) and (b), a resist film 7 is produced selectively on what is to be an active area in the memory device excepting the capacitor area, as shown in Figure 6(b). The area over which resist film 7 is produced corresponds to a transistor area. As a result, only the field area is left uncovered by masks (that is, uncovered either by mask 7 or mask 6).

An ion implantation process is employed for introducing P-ions, for example boron ions, into the entire surface of the wafer. As a result, a channel cut region 8 is produced beneath the silicion dioxide layer 2 for the purposes of isolating one memory cell from another. It is noted that this channel cut region 8 is connected with $p^+$ region 4 produced in the capacitor area of a memory cell.

Referring to Figure 7, the second mask 6 is removed. As shown in Figure 7, in fact, a portion of the second mask 6 remains in place under the resist film 7.

An evaporation process is employed to produce a polycrystal silicon layer 9 to a thickness of, for example, 200 to 300 nm over the entire surface of the wafer.

An ion implantation process is employed to introduce P- or N-type impurity into the polycrystal silicon layer 9 for the purpose of reducing the electrical resistance thereof.

Referring to Figure 8, the third resist film 7 together with the silicon layer 9 located thereon is removed by a solvent which dissolves the resist. This is a so-called lift-off process. The remaining silicon layer 9 parts will function as a field shield layer and one electrode of a capacitor, when grounded later.

Hereafter, an ordinary method is employed for production of an FET on the active region. Referring to Figure 9, the silicon dioxide layer 2 is removed from the transistor area, before another silicon dioxide layer 2G is grown on the substrate 1. It is noted that the thickness of the above mentioned silicon dioxide layer 2G is 1.5 times as large on the polycrystal silicon layer 9 as it is on the substrate 1. Further a process temperature of approximately 900°C is sufficient.

Referring to Figure 10, a silicon gate electrode 10 is produced, before an ion implantation process is employed for introduction of N-ions into a source region 11S and a drain region 11D. Finally, an ordinary method is employed for production of one or more inter-layer insulation layers, contact holes and electrodes to complete the production process.

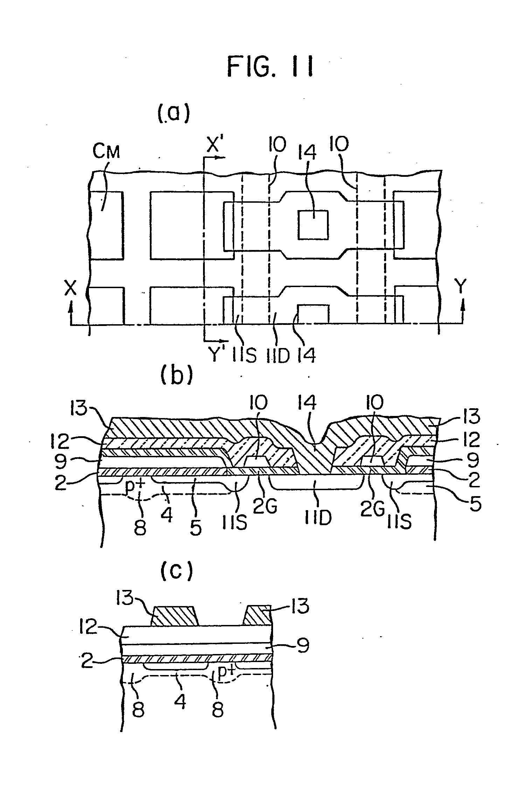

With reference to Figures 11(a), (b) and (c), the arrangement and configuration of a memory cell device which is one embodiment in accordance with this invention produced as described above is shown. Figure 11(a) is a schematic plan view of the semiconductor memory device. Figure 11(b) and 11(c) are schematic cross-sectional views of Figure 11(a), respectively, taken along lines X—Y and X'—Y'. 12, 13, and 14 are respectively a phospho silicate glass layer, an aluminium bit line and a contact hole. $C_M$ is a memory capacitor area. The silicon gate 10 functions as a word line.

The memory cell area and the memory capacitor area of the above described semiconductor memory device are respectively 47.5 $\mu m^2$ and 14.5 $\mu m^2$, based on the 1.5 $\mu m$, rule.

As is clear from the steps for production described above, a so-called 1-transistor and 1-capacitor type semiconductor memory device according to an embodiment of the invention has an arrangement and configuration, predominantly concerned with the capacitor part of the memory cell, which comprises (a) an insulator layer grown on a semiconductor substrate of one conductivity type, (b) a conductive layer grown on the insulator layer to provide one electrode of the capacitor, which continues into a field shield layer to form one unit with the field shield layer, (c) a first semiconductor region of a conductivity type opposite to that of the substrate, which is located beneath the insulator layer to provide the other electrode of the capacitor and the source for the transfer gate transistor, and (d) a second semiconductor region highly doped and of the same conductivity type as that of the substrate, which is located beneath the first semiconductor layer extending towards the field area but not extending towards the gate region of the transfer gate transistor, and being connected to the channel cut region in the field area.

Accordingly, a so-called 1-transistor and 1-capacitor type semiconductor memory device according to an embodiment of the invention has the advantages listed below.

(a) Since a field shield layer can be produced with a silicon semiconductor layer of which the pattern is defined by a self alignment system, the surface of the device can be made plane and suitable to accept a finer pattern.

(b) Since a thick silicon dioxide layer is not necessary for the field insulation or isolation, no high temperature heat treatment of long duration is required. Therefore, there is no possibility of the field silicon dioxide layer reducing the size of the active area.

(c) Since a means is provided for inhibiting the depletion layer from spreading in excess of a certain limitation, a large capacitance can be expected for the capacitor. Further, a long persistance time or memory holding time can be expected, because upward movement of electrons into the capacitance region from the substrate can be effectively prevented by the high impurity concentration region.

(d) Since a larger capacitance can be expected and the upward movement of electrons can be prevented as mentioned above, the device can be resistant to α-rays.

(e) Since the second semiconductor layer, highly doped with a conductivity type identical to that of the substrate, is isolated from the gate area, there is no possibility of threshold voltage being increased.

From the above description, it will be clear that a semiconductor memory device which is highly integrated, has a long persistance time (memory holding time), has a plane surface and is resistant to α-rays, can be provided.

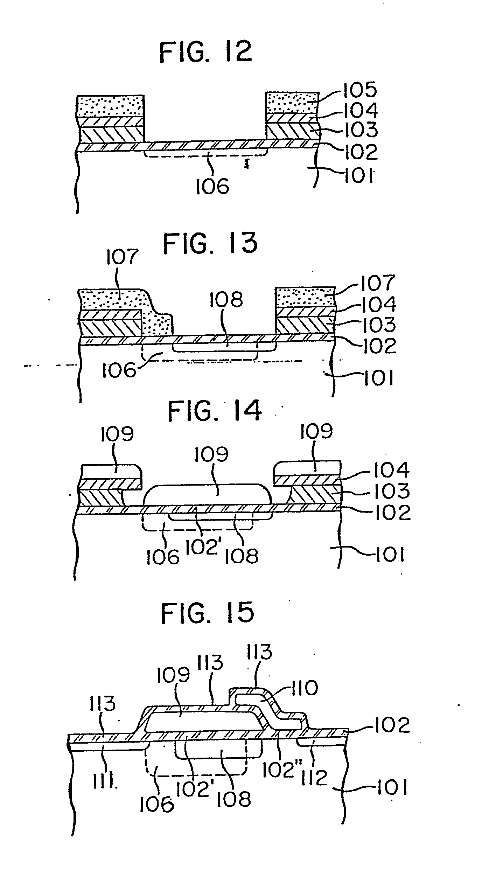

With reference to Figures 12 to 16, steps for production of, and the arrangement and configuration of, a semiconductor memory device according to another embodiment of the present invention will be described below, on the assumption that the device is produced on a P-doped silicon substrate. The major difference between the embodiment of Figures 12 to 16 and the embodiment of Figures 1 to 11 is that the embodiment of Figures 12 to 16 is provided with a word line which is connected with a gate and which is overlaid on a wafer and is provided with a bit line which is buried.

Referring to Figure 12, a first step is to grow a silicon dioxide layer 102 to a thickness of, for example, 50 nm on a P-doped silicon substrate 101. Any process can be accepted for this purpose. A second step is to grow a silicon nitride layer 103 to a thickness of, for example, 300 to 1000 nm on the silicon dioxide layer 102 employing a plasma chemical vapour deposition process. A third step is to grow a silicon nitride layer 104 to a thickness of, for example, 100 to 200 nm employing a chemical vapour deposition process. A fourth step is to etch an opening in the silicon nitride layer 103 and 104 covered by a resist film 105 employing a lithography process. A fifth step is to employ an ion implantation process for introducing boron ions into the substrate 101. 106 shows a $p^+$ region produced by the boron ion implantation.

Referring to Figure 13, a sixth step is to remove the resist film 105 from the entire surface. A seventh step is to produce another resist film 107 employing a different mask (not shown). An eighth step is to etch a portion of the silicon nitride layers 103 and 104 uncovered by the resist film 107 by a reactive sputter etching process. A ninth step is to employ an ion implantation process for introducing arsenic ions into the substrate 101. 108 shows an $n^+$ region produced by the arsenic ion implantation.

Referring to Figure 14, a tenth step is to remove the resist film 107. An eleventh step is to selectively remove a portion of the silicon nitride layers produced by a plasma deposition process and the silicon dioxide layer where uncovered by a wet etching process using a mixed solution of hydrogen fluoride and ammonium fluoride which is well known as buffer HF etching solution. In this step, the specific portions of the silicon nitride layers produced by a chemical vapour deposition process remain to form an overhanging structure, as shown in Figure 14. A twelfth step is to produce a silicon dioxide layer 102' at the bottom of the opening. A thirteenth step is to grow an amorphous silicon layer 109 on the entire surface of the wafer. An electron gun evaporation process or a sputtering process is preferable for growing the silicon layer 109. A fourteenth step is to introduce N or P type impurity ions into the silicon layer 109.

Referring to Figure 15, a fifteenth step is to immerse the wafer in hot phosphoric acid to remove the silicon nitride layers 103 and 104 together with portions of the silicon layer 109 placed thereon to carry out a lift-off process. A sixteenth step is to etch a portion of silicon dioxide layer 102 where not covered by the silicon layer 109 for preparing a space to produce a gate of a transfer transistor. A seventeenth step is to oxidize the wafer to produce a gate insulator layer 102''. During this process, the amorphous silicon is converted to a polycrystal silicon, and boron ions and arsenic ions (in regions 108 and 109) are activated and diffused downwards as shown in Figure 15. Further the $p^+$ region (106) is made deeper than the $n^+$ region (108). An eighteenth step is to grow a polycrystal silicon layer on the entire surface of the wafer, before a lithography process is employed for patterning a gate 110 made of the polycrystal silicon layer. A nineteenth step is to etch exposed portions of a silicon oxide layer 102 from the wafer. A twentieth step is to employ an ion implantation process for introducing arsenic ions into the wafer for the purpose of producing drain regions 111 and 112 functioning as bit lines, and to reduce the resistance of the polycrystal silicon electrode 109 for the capacitor. A twenty first step is to produce a silicon oxide layer 113 on the silicon layers by a thermal oxidation process.

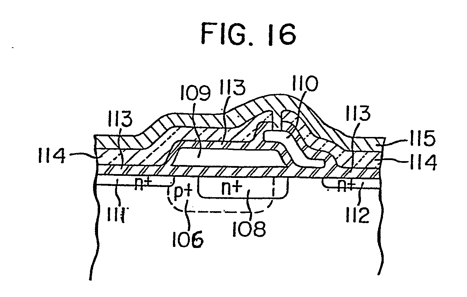

Thereafter, ordinary processes are employed to complete this semiconductor memory device which is another embodiment of this invention. Referring to Figure 16, phosphosilicate glass layer 114 is grown on a wafer, a contact hole is provided in the phosphosilicate glass layer 114, an annealing process is carried out, an aluminium layer 115 is formed on the phosphosilicate glass layer 114 and the aluminium layer 115 is patterned to form a word line.

Various means of improvement of so-called 1-transistor and 1-capacitor type memory cells as proposed, involve a degree of antimony. Configurations and processes, and combinations thereof, are provided by the present invention which are effected to solve problems prevailing. From the point of view of layer configuration, the congregation or uniting of a field shield electrode and one electrode of a capacitor of a memory cell and the additional arrangement of high impurity concentration layer just below the other electrode of the capacitor of the memory cell which layer extends to a field region to form a channel cut area but is inhibited from extending to the gate is effective in providing a so-called 1-transistor and 1-capacitor type memory cell which can be highly integrated, has a long persistence time and is resistant to α-rays.

**Claims**

1. A semiconductor memory device having a memory cell of the one transistor, one capacitor type, comprising a semiconductor substrate (1) of one conductivity type, the memory cell comprising an insulator layer (2) on the surface of the substrate, a first semiconductor region (5), of the opposite conductivity type to that of the substrate, beneath the insulator layer, providing one electrode of the capacitor, a second semiconductor region (4), of the same conductivity type as the substrate and with higher conductivity than the substrate, beneath the first semiconductor region, a conductive layer (9), above the insulator layer, over the first and second semiconductor regions, providing another electrode of the said capacitor, characterised in that

the second semiconductor region (4) is connected with a channel cut region (8) of the same conductivity type as the substrate and with higher conductivity than the substrate, in that

the channel cut region is provided beneath the insulator layer (2) in the field area, the field area comprising that part of the substrate which does not contain a capacitor or transistor region, and in that

the conductive layer (9) additionally overlies said field area so as to constitute both an electrode of the capacitor and a field shield electrode.

2. A device as claimed in claim 1, wherein the insulator layer does not cover a part of the surface of the substrate to be contacted by metal wiring.

3. A device as claimed in claim 1 or 2, wherein the second semiconductor region is relatively heavily doped (e.g. has a relatively high conductivity).

4. A device as claimed in any preceding claim, wherein the first semiconductor region is relatively heavily doped.

5. A device as claimed in any preceding claim, wherein the first semiconductor region provides also a source of a transfer gate transistor, and wherein the second semiconductor region does not extend up to the gate region of that transistor.

6. A device as claimed in any preceding claim, being a semiconductor memory device.

7. A method of manufacturing a semiconductor device as claimed in any preceding claim, wherein a thick field oxide layer is not employed or produced, and no long duration high temperature heat treatments are used for producing the channel cut region.

**Revendications**

1. Mémoire à semiconducteur comportant une cellule de mémoire du type à un transistor et un condensateur, comprenant un substrat semiconducteur (1) d'un type de conductivité, une cellule de mémoire comprenant une couche isolante (2) à la surface du substrat, une première région semiconductrice (5), du type de conductivité opposé à celui du substrat, située au-dessous de la couche isolante, en fournissant une électrode du condensateur, une seconde région semiconductrice (4), du même type de conductivité que le substrat, et de conductivité supérieure à celle du substrat, située au-dessous de la première région semiconductrice, une couche conductrice (9), située au-dessus de la couche isolante, sur les première et seconde régions semiconductrices, en fournissant une autre électrode du condensateur, caractérisée en ce que

la seconde région semiconductrice (4) est connectée à une région de coupure de canal (8) du même type de conductivité que le substrat et de conductivité supérieure à celle du substrat, en ce que

la région de coupure de canal est prévue au-dessous de la couche isolante (2) dans la zone de champ, la zone de champ comprenant la partie du substrat qui ne contient pas une région de condensateur ou de transistor, et en ce que

la couche conductrice (9) recouvre de plus la zone de champ de manière à constituer à la fois une électrode du condensateur et une électrode de protection de champ.

2. Mémoire selon la revendication 1, caractérisée en ce que la couche isolante ne recouvre pas une partie de la surface du substrat à mettre en contant par un câblage métallique.

3. Mémoire selon l'une quelconque des revendications 1 et 2, caractérisé en ce que la seconde région semiconductrice est relativement très dopée (par exemple qu'elle a une conductivité relativement élevée).

4. Mémoire selon l'une quelconque des revendications 1 à 3, caractérisée en ce que la première région semiconductrice est relativement très dopée.

5. Mémoire selon l'une quelconque des revendications 1 à 4, caractérisée en ce que la première région semiconductrice fournit également une source d'un transistor à grille de transfert, et en ce que la seconde région semiconductrice ne s'étend pas jusqu'à la région de grille de ce transistor.

6. Mémoire selon l'une quelconque des revendications 1 à 5, caractérisée en ce qu'elle constitue une mémoire à semiconducteur.

7. Procédé de fabrication d'un dispositif à semiconducteur selon l'une quelconque des revendications 1 à 6, caractérisé en ce qu'il consiste à ne pas utiliser ou produire une couche épaisse d'oxyde de champ, et à ne pas utiliser de traitements thermiques à haute température de longue durée pour produire la région de coupure de champ.

**Patentansprüche**

1. Halbleiterspeichervorrichtung mit einer Speicherzelle vom Ein-Transistor-, Ein-Kondensator-Typ, mit einem Halbleitersubstrat (1) von einer Leitfähigkeitsart, bei welcher die Speicherzelle eine Isolatorschicht (2) auf der Oberfläche des Substrats umfaßt, eine ersten Halbleiterbereich (5) von einem Leitfähigkeitstyp, der entgegengesetzt zu dem des Substrats ist, unterhalb der Isolatorschicht, der eine Elektrode des Kondensators bildet, einen zweiten Halbleiterbereich (4) vom selben Leitfähigkeitstyp wie das Substrat und mit höherer Leitfähigkeit als das Substrat, unterhalb des ersten Halbleiterbereichs, eine leitende Schicht (9) oberhalb der Isolatorschicht, über den ersten und zweiten Halbleiterbereichen, welche eine andere Elektrode des genannten Kondensators bildet, dadurch gekennzeichnet,

daß der zweite Halbleiterbereich (4) mit einem Kanalbegrenzungsbereich (8) vom selben Leitfähigkeitstyp wie das Substrat und mit höherer Leitfähigkeit als das Substrat verbunden ist,

daß der Kanalbegrenzungsbereich unterhalb der Isolatorschicht (2) in dem Feldbereich vorgesehen ist, welcher denjenigen Teil des Substrats umfaßt, der keinen Kondensator- oder Transistorbereich enthält, und

daß die leitende Schicht (9) zusätzlich über dem genannten Feldbereich liegt, um so sowohl eine Elektrode des Kondensators als auch eine Feldabschirmelektrode zu bilden.

2. Vorrichtung nach Anspruch 1, bei welcher der Isolator nicht einen Teil der Oberfläche des Substrats bedeckt, welches durch eine Metallverdrahtung kontaktiert werden soll.

3. Vorrichtung nach Anspruch 1 oder 2, bei welcher der zweite Halbleiterbereich relativ stark dotiert ist (d. h. eine relativ hohe Leitfähigkeit hat).

4. Vorrichtung nach einem der vorhergehenden Ansprüche, bei welcher der erste Halbleiterbereich relativ stark dotiert ist.

5. Vorrichtung nach einem der vorhergehenden Ansprüche, bei welcher der erste Halbleiterbereich auch die Source eines Überführungsgatetransistors bildet und bei welcher der zweite Halbleiterbereich sich nicht bis zu dem Gatebereich von diesem Transistor erstreckt.

6. Vorrichtung nach einem der vorhergehenden Ansprüche, welche eine Halbleiterspeichervorrichtung bildet.

7. Verfahren zur Herstellung einer Halbleitervorrichtung nach einerm der vorhergehenden Ansprüche, bei welcher eine dicke Feldoxidschicht weder verwendet noch erzeugt wird und keine langwährenden Behandlungen bei hoher Temperatur zur Erzeugung des Kanalbegrenzungsbereichs verwendet werden.

FIG. 1

2

1

FIG. 2

(a)

3A

3

2

1

(b)

3A

3

FIG. 3

3

2

4   5   1

FIG. 4

6

3

2

4   5   1

FIG. 5

2

1

1

# FIG. 6

### (a)

### (b)

# FIG. 7

# FIG. 8

# FIG. 9

# FIG. 10

# FIG. 11

## (a)

## (b)

## (c)

## FIG. 12

105
104
103
102
101

106

## FIG. 13

107
107
108
104
103
102
101

106

## FIG. 14

109
109
109
104
103
102
101

106 102' 108

## FIG. 15

109 113 113
113 110
102
111
102" 112 101
106 102' 108

## FIG. 16